Europäisches Patentamt

European Patent Office

Office européen des brevets

(19)

(11) **EP 1 044 500 B1**

(12) **EUROPÄISCHE PATENTSCHRIFT**

(45) Veröffentlichungstag und Bekanntmachung des Hinweises auf die Patenterteilung:
**23.10.2002 Patentblatt 2002/43**

(51) Int Cl.7: **H03H 9/02**

(21) Anmeldenummer: **98966572.4**

(22) Anmeldetag: **22.12.1998**

(86) Internationale Anmeldenummer:
**PCT/DE98/03769**

(87) Internationale Veröffentlichungsnummer:
**WO 99/035738 (15.07.1999 Gazette 1999/28)**

(54) **OBERFLÄCHENWELLEN-(SAW-)BAUELEMENT AUF AUCH PYROELEKTRISCHEM EINKRISTALL-SUBSTRAT**

SURFACE ACOUSTIC WAVE COMPONENT ON A MONOCRYSTAL SUBSTRATE WHICH IS ALSO PYROELECTRIC

COMPOSANT A ONDES ACOUSTIQUES DE SURFACE SUR SUBSTRAT MONOCRISTALLIN EGALEMENT PYROELECTRIQUE

(84) Benannte Vertragsstaaten:
**DE FR GB**

(30) Priorität: **30.12.1997 DE 19758198**

(43) Veröffentlichungstag der Anmeldung:
**18.10.2000 Patentblatt 2000/42**

(73) Patentinhaber: **EPCOS AG**
**81541 München (DE)**

(72) Erfinder: **RUILE, Werner**
**D-80636 München (DE)**

(74) Vertreter: **Epping, Wilhelm, Dipl.-Ing. et al**
**Epping Hermann & Fischer**
**Postfach 12 10 26**
**80034 München (DE)**

(56) Entgegenhaltungen:
**EP-A- 0 534 252      EP-A- 0 785 620**
**US-A- 4 952 832**

• **FUMIO TAKDA ET AL: "HIGH VELOCITY AND HIGH COUPLING SURFACE ACOUSTIC WAVES..." JAPANESE JOURNAL OF APPLIED PHYSICS, SUPPLEMENTS., Bd. 24, Nr. 24, 1985, XP002103219 TOKYO JA**

**Beschreibung**

Die vorliegende Erfindung bezieht sich auf ein elektronisches, mit akustischen Wellen arbeitendes Oberflächenwellen-(SAW-)Bauelement auf insbesondere Lithiumtantalat-/niobat-Substrat. Ohne daß dies jeweils wiederholt wird, ist die Erfindung auch für Kaliumniobat und dgl. für solche Bauelemente als Substratkristall verwendete Materialien anwendbar.

Für die Verwendung und den Betrieb eines solchen Bauelementes insbesondere für Handgeräte des Mobilfunksektors, kommt es darauf an, vorzugsweise das (mit der Antenne unmittelbar verbundene) Ausgangs-/Eingangsfilter so zu konzipieren, daß es einerseits eine hohe Leistungsverträglichkeit (z.B. 2 Watt angebotene Leistung) aufweist und andererseits insbesondere eine extrem kleine Einfügungsdämpfung hat.

Ein einschlägiges Oberflächenwellenfilter ist z.B. aus DE-A-2802946 bekannt. Es besteht (siehe Figur 7) im wesentlichen aus einem piezoelektrischen Substratplättchen 1, wie z.B. Lithiumtantalat, auf dessen ausgewählt orientierter Substratoberfläche 2 Elektrodenstrukturen 12 wie Interdigitalstrukturen und dgl. aufgebracht sind. Zwischen diesen Strukturen verlaufen im Betrieb LSAW-(Leaky Surface Acoustic Waves) Wellen oder HVPSAW-(high velocity pseudo)Wellen (siehe auch Ultrasonic Symp. Proc. 1994, p. 281-286). Diese Elektrodenstrukturen und sich ausbreitenden Wellen 13 dienen der selektiven/filternden elektrischen Signalübertragung.

Es ist bekannt, daß für eine solche Reflektor-/Elektrodenstruktur (im Folgenden insgesamt lediglich als Elektrodenstrukturen bezeichnet) mit z.B. interdigitalen Elektrodenfingern, Reflektorfingern und dgl. (im Folgenden insgesamt auch lediglich als Finger bezeichnet), nicht nur die Folge der Anordnung der Finger 112 und ihrer Abstände, sondern, nämlich für ausreichend hohes Reflexionsvermögen dieser Finger, auch für die Dicke (Höhe) der Finger ein vorgegebenes Maß (vorzugsweise innerhalb einer Toleranzbreite) einzuhalten ist.

Aus dem Stand der Technik ist es bekannt, für eine hohe Leistungsverträglichkeit besondere Maßnahmen für die auf der Substratoberfläche aufgebrachten Elektrodenstrukturen vorzusehen. Im allgemeinen bestehen diese Elektrodenstrukturen aus z.B. photolithographisch strukturiertem Aluminium. Solche Strukturen aus reinem Aluminium sind in mehrfacher Weise relativ unbeständig. Zur Steigerung der Leistungsverträglichkeit hat man das Aluminium mit Kupfer legiert oder SandwichAufbau aus Aluminium und Kupfer vorgesehen. Nachteilig ist dabei, daß Korrosion bei einer solchen Materialkombination auftritt. Dem Aluminium Titan zuzumischen, führt zu höherem elektrischem Widerstand einer aus dieser Kombination bestehenden Elektrodenstruktur. Ein weiterer beschrittener Weg ist, das Aluminium mit [111]-Textur auf dem Substrat aufzubringen, wozu eine vorherige Bekeimung von dessen Abscheidefläche erforderlich ist. Dies bedingt nicht nur höheren technologischen Aufwand sondern es läßt auch die Reproduzierbarkeit einer solchen texturierten Aluminiumschicht zu wünschen übrig. Ein ausgesprochen kostspieliges Herstellungsverfahren ist das epitaktische Aufwachsen des Aluminiums einer Elektrodenstruktur. Durch Aufsputtern des Aluminiums unter entsprechend ausgewählten Bedingungen kann auch eine kleine Kornstruktur des Aluminiums für erhöhte Leistungsverträglichkeit erzeugt werden. Zur Bildung der Elektrodenstruktur kann dabei aber nachteiligerweise nicht die ansonsten vorteilhafte (und für die Erfindung bevorzugt verwendete) photolithographische Lift-Off-Technik angewendet werden.

Es ist oben auch die wünschenswert kleine Einfügungsdämpfung für das Bauelement erwähnt. Aus dem Stand der Technik (DE-A-19641662 und DE-C-2802946) ist es bekannt, geringe Einfügungsdämpfung des Oberflächenwellen-Filters dadurch zu erreichen, daß als Substratplättchen ein Kristall eines um einen Winkel θ gedrehten Schnittes (rot y) verwendet wird. Das Substratplättchen 1 hat eine Oberfläche 2, der ein Achsensystem x1, x2, x3, mit x2 als Normale N dieser Oberfläche und mit in dieser Oberfläche liegenden Achsen x1 und x3 zugeordnet ist. Die bekannte Orientierung des kristallographischen Achsensystems x, y, z ist derart, daß die x-Achse mit der Achse x1 zusammenfallend in der Ebene des Kristallschnittes, d.h. in der Substratoberfläche liegt, und diese kristallographische x-Achse und die Richtung der Wellenausbreitung 13 in dem Bauelement parallel zueinander ausgerichtet sind. Die y-Achse des Kristalls steht im Stand der Technik der Drehung (rot y) entsprechend im Maß des Drehwinkels θ schräg zur Normalen N der Substratoberfläche auf dieser. Die z-Achse nimmt damit den gleichen Winkel θ zur x1-x3-Ebene, d.h. zur Substratoberfläche, ein. Die oben genannten Druckschriften geben für einen Winkel θ für das Lithiumtantalat zum einen einen Winkelbereich zwischen 38° und 46° und zum anderen einen solchen von 33° bis 39° an. Für das Lithiumniobat sind Winkel mit 66° bis 74° und 41° bekannt.

Aus der EP 0 785 620 A ist es bekannt, daß sich ein Oberflächenwellen-Bauelement aus kristallinem Lithiumtantalat oder - niobat beim Durchlaufen einer Temperaturdifferenz elektrisch auflädt.

Aufgabe der vorliegenden Erfindung ist es, ein Konzept eines einschlägigen Oberflächenwellen-Bauelementes(-Filters) anzugeben, das die wie oben dargelegt erforderliche Leistungsverträglichkeit aufweist und vorzugsweise auch minimierte Einfügungsdämpfung hat.

Diese Aufgabe wird mit den Merkmalen des Patentanspruches 1 oder 2 oder 4 gelöst. Weitere Ausgestaltungen und Weiterbildungen der Erfindung gehen aus den Unteransprüchen hervor.

Die Erfindung wird (ohne daß sie dadurch als eingeschränkt gelten sollte) nachfolgend an einem Beispiel mit Lithiumtantalat-Einkristallsubstratplättchen beschrieben.

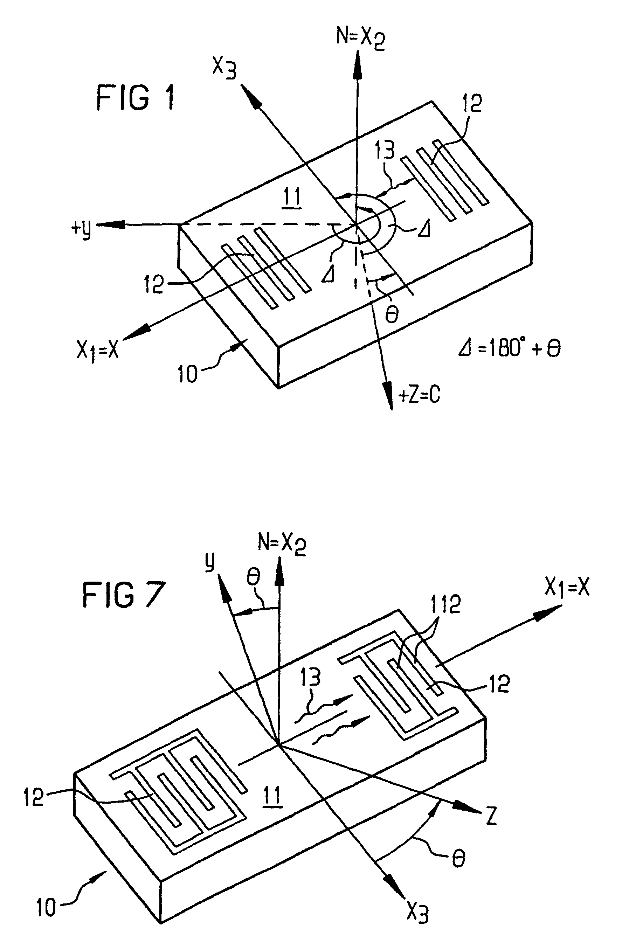

Zur Lösung dieser Aufgabe ist eine vom Stand der Technik wesentliche abweichende kristallographische Orientierung der für die Elektrodenstrukturen 12 vorgesehenen Oberfläche des hier verwendeten Substratplättchens ausgewählt. Die +z-Achse, die auch die pyroelektrische Achse ist, steht in einem Winkel $\Delta$ zur x1-x2-Ebene, d.h. ist zur Substratoberfläche 11 in das Substratplättchen hinein ausgerichtet (so daß die negative z-Achse in der Figur 1 von der Substratoberfläche nach oben zeigt). Die x3-Achse ist gegenüber der +z-Achse (entgegen der x1-Achse gesehen) im Gegen-Uhrzeigersinn (siehe auch Figur 1) um den Winkel $\Delta$ gedreht. Der gleiche Winkel $\Delta$ liegt damit auch zwischen der Normalen N (= x2-Achse) und der +y-Achse vor. Bevorzugt ist die erfindungsgemäße Bemessung des Winkels $\Delta = 180° + \theta$, wobei $\theta$ ein Winkel insbesondere zwischen etwa 25° und 46° ist.

Dieser Winkel $\theta$ kann für ein jeweiliges Kristallmaterial wie Lithiumtantalat, Lithiumniobat, Kaliumniobat und dgl. insbesondere so groß gewählt sein, wie dies im Stand der Technik (wie oben beschrieben) für bekannte Oberflächenwellen-Bauelemente mit rot y-Kristallschnitt üblich ist.

Mit anderen Worten heißt dies, daß gegenüber dem Stand der Technik hier bei der Erfindung die (parallele) Rückseite des z.B. jeweilig bekannten Schnittes des Substratplättchens als Substratoberfläche für die Elektrodenstrukturen verwendet wird. Diese bisher im Stand der Technik nicht angewendete erfindungsgemäße Maßnahme ist hinsichtlich der aufgabengemäßen Erhöhung der Leistungsverträglichkeit eines Oberflächenwellen-Bauelements eine (wie noch dargelegt wird) überraschend vorteilhafte Maßnahme.

Lithiumtantalat und dergleichen ist ein nicht nur piezoelektrischer sondern auch ein pyroelektrischer Kristall. Die erfindungsgemäß für die Elektrodenstrukturen/Finger verwendete Plättchen-Oberfläche lädt sich aufgrund der im erfindungsgemäßen Winkel $\Delta = (180° + \theta)$ gewählten Ausrichtung ihrer Flächennormalen N gegenüber der pyroelektrischen Achse (gleich der Z-Achse des Kristalls) auf eine positive Spannung gegenüber dem Substratplättchen bzw. gegenüber dessen gegenüberliegende, rückseitige Oberfläche des Plättchens auf, und zwar dies dann, wenn es zu einer Erwärmung des Substratplättchens oder wenigstens seines oberflächennahen Bereichs unterhalb der Elektrodenstrukturen kommt.

Eine solche Erwärmung tritt tatsächlich dann auf, wenn es zu einer größeren betriebsmäßigen Belastung des Oberflächenwellen-Bauelements als Oszillator, Filter und dgl. kommt. Dieser Prozeß der Erwärmung und der damit verbundenen positiven Aufladung tritt also insbesondere und vorzugsweise nahe den Elektrodenstrukturen in derjenigen Oberfläche des Substratplättchens auf, die wie hier erfindungsgemäß (nämlich anders als im Stand der Technik) für die Aufbringung der Elektrodenstrukturen/Finger ausgewählt ist.

Der mit der Erfindung zu erzielende eigentlich interessierende Effekt ist, daß mit der positiven Aufladung der erfindungsgemäß ausgewählten Oberfläche negative Ladungen aus dem Substratplättchen zu dieser Oberfläche gezogen werden. Insbesondere sind dies negativ geladene Sauerstoffionen. Diese wirken in situ an dem Aluminium der Elektrodenstrukturen derart, daß sich im Wirkungsbereich dieser Sauerstoffionen ein stabiles Aluminiumoxid bildet. Für die Erfindung vorteilhaft erhöht dieses Aluminiumoxid die Leistungsverträglichkeit des Oberflächenwellen-Bauelements, insbesondere die Haftfestigkeit der Aluminium-Elektrodenstruktur auf der erfindungsgemäß ausgewählten Substratoberfläche. Die gerade bei hoher elektronischer Belastung des Bauelements auftretende Selbsterwärmung desselben bewirkt somit erfindungsgemäß eine verstärkte Oxidation mit dem einhergehenden Vorteil.

Mit der Erkenntnis dieser "inneren" Wirkungsweise der Erfindung ist der Fachmann in der Lage, die Erfindung auch bei anderen hier nicht genannten pyroelektrischen Kristallen anzuwenden, also die üblichen Elektrodenstrukturen aus im wesentlichen Aluminium auf der sich bei (im Betrieb auftretender) Erwärmung positive aufladenden ausgewählten Substratoberfläche vorzusehen und die somit aufgabengemäß gesteigerte Leistungsverträglichkeit zu erzielen.

Für diesen erfindungsgemäßen Effekt für erhöhte Leistungsverträglichkeit ist die exakte Größe des Winkels $\Delta$ (hier als 180° + $\theta$ mit den oben angegebenen Maßen bzw. Grenzen für den Winkel $\theta$) für die Ausrichtung der pyroelektrischen Achse des (Lithiumtantalat- und dgl.)Kristalls bezüglich der für die Elektrodenstrukturen verwendeten Oberfläche des Substratplättchens soweit relativ unkritisch, als dies das Vorzeichen der oben beschriebenen Oberflächen-Aufladung, d.h. den für die Erfindung genutzten Effekt, nicht beeinflußt. Höhere Erwärmung durch vergrößerte Verlustleistung führt sogar zu stärkerer Oxidationswirkung im Aluminium. Entsprechend der Wahl des Winkels $\theta$ im Hinblick auf geringere bzw. minimierte Leckwellenverluste empfiehlt es sich aber trotzdem auch bei der Erfindung für den Winkelanteil $\theta$ (in $\Delta = 180° + \theta$) ein solches Winkelmaß, insbesondere die bekannten Winkelwerte zu wählen, mit dem dann auch hier geringe Leckwellenverluste angestrebt sind.

Zur weiteren Erläuterung sei die nachfolgende Beschreibung zu den zur Erfindungsbeschreibung gehörenden anliegenden Figuren gegeben.

Figur 1   zeigt das Prinzip der erfindungsgemäßen kristallographischen Ausrichtung der Substratoberfläche, bezogen auf dessen Achsensystem x1, x2, x3,

Figuren 2, 3 und 4   zeigen Weiterbildungen der Erfindung und

Figuren 5, 5a und 6   zeigen Erläuterungen zur Dickenbemessung und

Figur 7          zeigt Stand der Technik.

Die Figur 1 zeigt die Oberfläche 11 des Substratplättchens 10 mit den Angaben der Orientierungen der auf diese Oberfläche 11 (Schnittfläche des Kristalls) erfindungsgemäß bezogenen Lage der Kristallachsen x, y, z des beispielsweise Lithiumtantalatkristalls. Zusätzlich eingetragen ist die Normale N der Substratoberfläche 11. Diese Fläche 11 ist ein um die x-Achse gedrehter y-Schnitt mit der angegebenen erfindungsgemäßen Ausrichtung der Kristallrichtung y und der entsprechenden angegebenen Ausrichtung der z-(c-)Kristall-/Pyroachse des Lithiumtantalats. Wie ersichtlich, ist diese z-Achse in der perspektivischen Darstellung der Figur 1 nach unten in das Substratplättchen 10 gerichtet und hat zur (x1-x3-)Ebene der Substratfläche 11 den erfindungsgemäß bemessenen Winkel $\Delta = 180° + \theta$ mit einem Winkel $\theta$ zwischen z.B. 25° bis 46°, vorzugsweise zwischen 33° und 37°. Für Lithiumniobat sind dies Winkel zwischen 60° und 74° sowie zwischen 33° und 47°. Insbesondere kann der Winkel $\theta$ das Maß der im Stand der Technik angegebenen Winkel $\theta$ für minimale Einfügungsdämpfung, bezogen auf das jeweilige Kristallmaterial, haben. Dieser Winkel $\Delta$ tritt im übrigen auch als Drehwinkel der (positiven) y-Achse gegenüber der Normalen N der Substratoberfläche auf, entsprechend der Drehung rot y des Kristallschnitts um die x = x1-Achse auf.

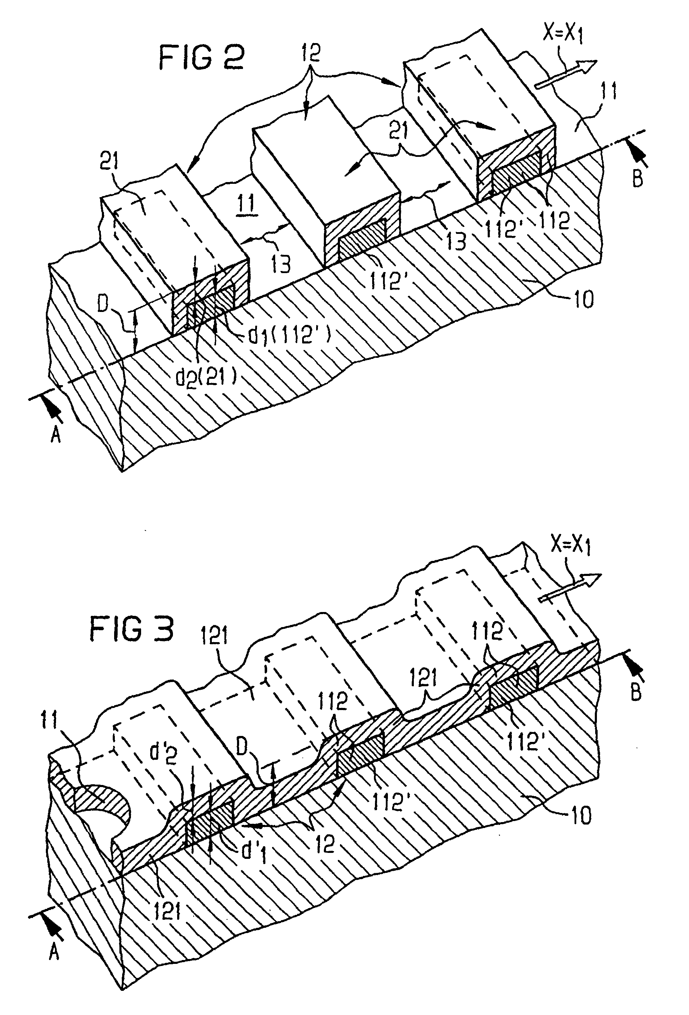

Die Figuren 2 bis 4 und die Figuren 5 und 6 zu deren Erläuterung zeigen Weiterbildungen der Erfindung, die in einer in der Oberfläche der Elektrodenstrukturen 12/Finger 112 erzeugten bzw. auf dieser Oberfläche aufgebrachten, gegenüber dem Aluminium oder dgl. der Elektrodenstrukturen harten Schicht 21, 121 bestehen. Diese Maßnahme kann vorteilhaft zusätzlich zur aufgabengemäßen Optimierung der Leistungsverträglichkeit bei der hier vorliegenden Erfindung mit Substratplättchen mit der Drehung um den Winkel $\Delta$ vorgesehen sein.

Als hier vorzusehende harte Schicht kann eine Aluminiumoxidschicht auf den Aluminium-Elektrodenstrukturen vorgesehen sein. Insbesondere kann diese Aluminiumoxidschicht auf dem Aluminium der Elektroden durch anodische Oxidation von der Oberfläche der Elektrodenstruktur her in das Aluminium hinein derselben bewirkt sein. Bevorzugte Dicke dieser erfindungsgemäßen harten Schicht liegt zwischen 50 nm und 500 nm. Ein solches Maß der harten Schicht liegt in etwa bei 10% bis 80% der Dicke der Elektrodenstruktur mit der Schicht auf dem Substrat.

Eine allgemeiner gültige physikalische Definition für den Begriff "hart" ist die, daß für das Material dieser harten Schicht gilt, daß in diesem Material die Schallgeschwindigkeit für die bei dem Bauelement vorgesehene relevante akustische Welle (z.B. etwa 80%) größer als die Schallgeschwindigkeit im elektrisch leitenden Material der Elektrodenstruktur, d.h. in deren Anteil an Aluminium bzw. Aluminiumlegierung ist. Zum Beispiel beträgt die Schallgeschwindigkeit für eine scherpolarisierte (LSAW-)Welle in Aluminiumoxid etwa 5300 m/s und in Aluminium nur etwa 3000 m/s.

Um weitere erhöhte Leistungsverträglichkeit zu erzielen, ist eine ausreichend dicke Schicht dieses hier definierten harten Materials auf der Elektrodenstruktur bzw. als integraler Bestandteil derselben erforderlich. Für die Erfindung ist wichtig zu beachten und zu berücksichtigen, daß hier - anders als bei bekanntermaßen vorgesehenen Passivierungsschichten auf Oberflächenwellen-Bauelementen- die Dicke des Materials der erfindungsgemäß vorgesehenen harten Schicht als Anteil der für die erforderliche akustische Reflexionswirkung bekanntermaßen vorzusehenden Gesamtschichtdicke der Elektrodenstruktur/Finger zu bemessen ist. Zum Beispiel ist für eine LSAW-Welle im 1 GHz-Bereich eine Fingerdicke von etwa 400 nm (2 GHz = etwa 200 nm) als vorteilhaft angepaßt physikalisch vorgegeben. Für die aufgabengemäß erhöhte Leistungsverträglichkeit wird insbesondere angestrebt, daß eine aus den Schallgeschwindigkeitswerten des Elektrodenmaterials und der erfindungsgemäß vorgesehenen harten Schicht (z.B. Aluminiumoxid) sich für die Oberflächenwelle in praxi ergebende resultierende Schallgeschwindigkeit in etwa gleich der Schallgeschwindigkeit der Welle im Substratmaterial ist. (Für das hier relevante Lithiumtantalat/-niobat beträgt diese Schallgeschwindigkeit etwa 4000 m/s.) Erfindungsgemäß wird also zusätzlich eine Obigem entsprechende Dickenrelation zwischen der Dicke der erfindungsgemäß vorgesehenen harten Schicht und dem elektrisch leitenden Material der Elektrodenstruktur gewählt, daß die Gesamtdicke (harte Schicht + leitendes Material) z.B. für das obige Beispiel 1 GHz diese 400 nm beträgt. Zum Beispiel ergeben sich hiernach 150 nm Aluminiumoxid auf 250 nm Aluminium (-legierung) als erfindungsgemäß bemessene Dickenrelation innerhalb obiger "Gesamtdicke".

Zur oben genannten Gesamtdicke der Elektrodenstruktur/Figur sei angemerkt, daß dieses Dickenmaß zwischen 3% und 15% der Wellenlänge der genannten Oberflächenwellen betragen kann, typischerweise jedoch bei etwa 10% (= 400 nm bei ca. 1 GHz) liegt.

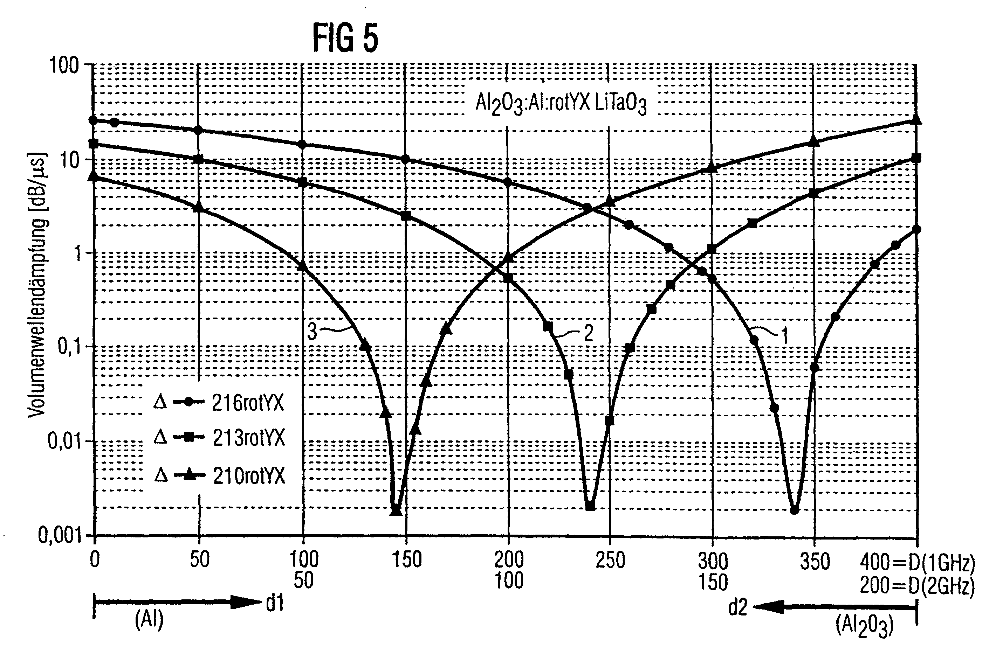

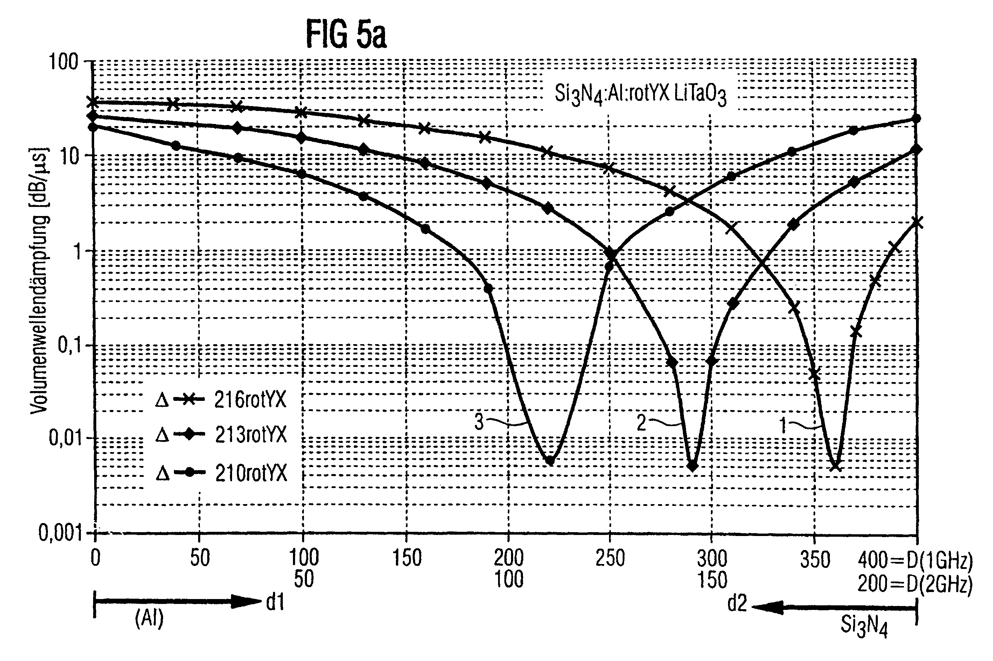

Diese Weiterbildung der Erfindung kann noch ein weiteres Merkmal zur Lösung der Aufgabe höherer/optimierter Leistungsverträglichkeit einschließen. Es ist dies eine auch an die harte Schicht angepaßte Wahl des oben erwähnten Winkels $\Delta$ des gedrehten (rot y)-Kristallschnittes vorzusehen. Es ist nämlich festgestellt worden, daß für optimale nutzbare Hochfrequenz-Leistungsverträglichkeit eine Abhängigkeit besteht von - und zwar abhängig voneinander - einerseits voranstehend angegebenem erfindungsgemäß gewählten Dickenverhältnis (harte Schicht zu elektrisch leitendem Anteil der Finger) und andererseits der Wahl des (Winkelanteils $\theta$ des) Winkels $\Delta$ für die Oberfläche mit der Normalen N des Substratplättchens. Hierzu sei zur weiteren Erläuterung auch auf die noch folgende Beschreibung zu den Figuren 5 und 6 hingewiesen.

Ein anderer Weg als die anodische Oxidation zur Erzeugung einer erfindungsgemäß vorgesehenen harten Schicht auf auch aus anderem elektrisch leitenden Material als Aluminium bestehenden Elektrodenstrukturen und ggfs. auch auf den sie umgebenden Bereichen ist das Aufsputtern, das CVD-(Chemical Vapor Deposition)-Verfahren, das MBE-(Molekülstrahl-Epitaxie)-Verfahren und dgl. anderes Beschichtungsverfahren. Für das Aufsputtern und dgl. vorgenannte Abscheideverfahren kommen insbesondere Siliziumnitrid, Aluminiumnitrid, Bornitrid, Silizide, Carbide, Boride und dgl. sowie auch amorphe Kohlenstoffschichten und/oder auch eine Diamant-Beschichtung in Frage.

Es kann im Einzelfall von Vorteil sein, nur die (Elektroden-)Finger mit der erfindungsgemäß vorgesehenen harten Schicht zu versehen und für die die Finger verbindenden Sammelschienen (busbars) einen vollen Querschnitt des elektrisch leitenden Materials der Elektrodenstruktur vorzusehen.

Für über die Elektrodenstrukturen hinausreichende fakultative Beschichtung ist darauf zu achten, daß die auf der Substratoberfläche üblicherweise vorgesehenen Bond-Flächen für das nachfolgende Bonden der Anschlußdrähte freigelassen bleiben, es sei denn, daß ein nachträgliches Wiederfreimachen dieser Bond-Flächen bevorzugt ist. Solche wie vorgenannt insbesondere aufgesputterten Schichten haben vorzugsweise eine Dicke zwischen 30 nm und 150 nm für z.B. 400 nm Gesamtdicke.

Eine noch weitere für die Erfindung relevante Alternative ist eine solche erfindungsgemäß vorgesehene harte Schicht über den Elektrodenstrukturen erst nach Einbau des Substratplättchens in das Bauelementgehäuse und nach dem Bonden der Anschlüsse im noch offenen Gehäuse auszuführen.

Auch für diese Alternativen der Aufbringung der erfindungsgemäß harten Schicht gilt wieder das Einhalten des Dickenverhältnisses von harter Schicht zu leitendem Anteil der Fingerstrukturen und vorzugsweise die Anpassung des Winkelanteils θ des Winkels Δ.

Figur 2 zeigt als Ausschnitt im Schnitt A-B (Figur 1) den Substratkörper 10 mit auf seiner Oberfläche angeordneten Fingern 112 einer Elektrodenstrukturen 12 und mit jeweils auf deren elektrisch leitendem Anteil 112' erfindungsgemäß vorgesehener harter Schicht 21. Insbesondere ist dies eine (die freiliegende Oberfläche der Finger 112) anodisch oxidierte Aluminiumoxidschicht.

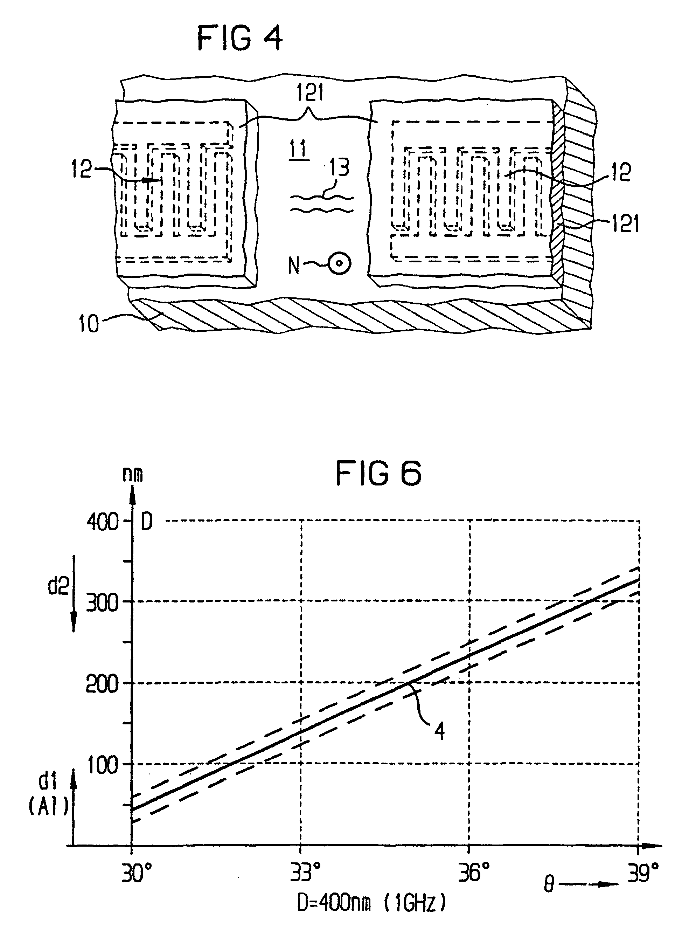

Die Figur 3 zeigt wie Figur 2 eine alternative Ausführungsform für eine erfindungsgemäß vorgesehene harte Schicht 121, die durch z. B. Aufsputtern aufgebracht ist. Diese Schicht 121 kann sich dabei mehr oder weniger auch, wie auch die Aufsicht der Figur 4 zeigt, auf von den Elektrodenstrukturen 12, insbesondere in deren Umgebung, nicht bedeckte Oberflächenanteile der Substratoberfläche 11 erstrecken. Das Maß für eine solche Erstreckung über die Elektrodenstrukturen 12 hinaus ist in Abwägung gegenüber möglichen negativen Einflüssen wie Dämpfung und dgl. auszuwählen.

Mit D ist die Gesamtdicke der Elektrodenstruktur 12 bzw. der Finger 112 und mit d1 bzw. d'1 die Dicke des elektrisch leitenden (Aluminium-)Anteils 112' und mit d2 bzw. d'2 die Dikke der harten Schicht 21 bzw. 121 bezeichnet.

Die Figur 5 zeigt auf der Abszisse den Anteil der Dicke (d1 in Figur 2) des Aluminiums der Elektrodenstruktur/Finger, bezogen auf die Gesamtdicke D der Finger (400 nm für 1 GHz bzw. 200 nm für 2 GHz). Auf der Ordinate ist das Maß der Wellendämpfung aufgetragen. Die in dem Diagramm der Figur 5 eingetragenen Kurvenzüge 1, 2, 3 gelten für die angegebenen drei voneinander verschiedenen Kristallschnitte. Aus dieser Darstellung der Figur 5 ist (ggfs. auch interpoliert) zu erkennen, wie groß der Winkel Δ für eine gewählte Dicke d1 des Aluminiumanteils an der Gesamtdicke D bzw. welches Dickenverhältnis d1:d2 bei einem Kristallschnitt mit vorgegebenem Winkel Δ erfindungsgemäß zu wählen ist. Die Figur 6 zeigt die interpolierte Kurve 4 für jeweils zu wählende Dickenverhältnisse für Kristallschnitte von Δ = 210° bis Δ = 218°, nämlich um mit der Lehre der Erfindung die gestellte Aufgabe zu lösen. In einem Toleranz-Streifen entlang der Interpolationskurve 4 liegen die die Erfindung erfüllenden optimalen Bemessungen für voneinander abhängigem Kristallschnittwinkel Δ und Dickenverhältnis d1:d2, bezogen auf die durch die vorgegebene Betriebsfrequenz vorgegebene optimale Gesamtdicke D der Finger bzw. der Elektrodenstruktur.

Die Figuren 5 und 6 geben die Bemessungen für Lithiumtanalat-Kristall an. Entsprechende Kurvenblätter gelten für z.B. Lithiumniobat mit jeweils etwas abweichenden Zahlenwerten jedoch prinzipiell gleichem Verhalten der Kurven (Figur 5) und der Interpolationslinie (4 in Figur 6). Der Figur 5a sind (für Figur 2) die Winkel der Dämpfungsminima für Siliziumnitrid als harte Schicht zu entnehmen.

Die Angaben und Bemessungsrichtlinien der Figuren 5 und 6 gelten quantitativ im wesentlichen für eine Ausführungsform mit (wie in Figur 2) harter Schicht auf nur den Fingern 112 mit zwischen den Fingern 112 (wenigstens weitgehend) freier Substratoberfläche 11. Für eine Ausführungsform nach Figur 3 gelten sie jedoch weiterhin qualitativ. Eine wie in Figur 3 über die Finger hinweg durchgehende erfindungsgemäß harte Beschichtung der Substratoberfläche 11 sollte bei z.B. einem Verhältnis Fingerbreite zu Fingerperiodenlänge von 0,5 zu 1 (= Metallisierungsverhältnis η = 0,5) nicht dicker als (d'2 = 0,3 x D =) 30% der vorgegebenen Gesamtdicke sein. Zum Beispiel wäre bei einem Kristallschnitt 36° für 1 GHz mit D = 400 nm die Dicke d'2 der harten Schicht bei einem Metallisierungsverhältnis 0,5 von 150 nm bei Figur 2 auf 75 nm für eine Ausführung nach Figur 3 zu reduzieren, um weiterhin optimale geringe Leckwellenverluste zu erreichen.

Für ein größeres Metallisierungsverhältnis, z.B. 0,7 ist die optimale Bemessung d'2 nur um etwa 30% auf etwa 105 nm zu reduzieren. Aus diesen Angaben lassen sich die Zwischenwerte in sinngemäßer Weise für den Einzelfall abschätzen.

Es können folgende Bemessungsrichtlinien angegeben werden: Bei einer Ausführungsform nach Figur 3 mit abgeschiedener Schicht 121 und bei einem Metallisierungsverhältnis η von 0,4 bis 0,8 und einer Gesamtdicke D = d'1 + d'2 = 0,03 bis 0,15-fachem der Wellenlänge der Oberflächenwelle gilt wenigstens angenähert, daß die maximale Dicke d'2 der Schicht 121 auf dem elektrisch leitenden Teil 112' der Finger abhängig vom Maß des vorliegenden Metallisierungsverhältnisses gegenüber den aus den Figuren 5, 5a und 6 zu entnehmenden Dickenwerten d2 für wie beim Ausführungsbeispiel der Figur 2 nur die Finger 112, d.h. nicht auch deren Umgebung bedeckende Schicht (21), reduziert zu bemessen ist, und zwar d'2 = η x d2.

Es läßt sich auch eine entsprechende Reduktionsformel

$$d'1{:}d'2 = \frac{(d1{:}d2) + (1 - \eta)}{\eta}$$

angeben, worin d1 und d2 Wertepaare mit zugehörigem Winkel θ sind, die sich aus den Figuren 5, 5a und 6 für eine diesbezügliche Ausführung nach Figur 2 ergeben.

Außer für die angegebenen Kristall-Materialien ist die Erfindung anwendbar auch für solche weitere Kristallmaterialien mit einem solchen Kristallschnitt der für die Elektrodenstrukturen vorgesehenen Oberfläche 11, für die die pyroelektrische Achse c = z in das Substratplättchen 10 hinein ausgerichtet orientiert ist (Drehwinkel D größer mehr als 180° und kleiner weniger als 360°).

**Patentansprüche**

**1.**   Oberflächenwellen-Bauelement,
mit einer Elektrodenstruktur (12,112) aus Aluminium als wenigstens Haupt-Materialbestandteil derselben auf einer Oberfläche (11) mit der Flächennormalen (N) eines pyroelektrischen und piezoelektrischen Kristall-Substratplättchens (10) aus Lithiumtantalat, wobei diese Oberfläche (x1, x2, x3, 11) ein solcher Kristallschnitt (x, y, z) ist, daß diese Oberfläche sich bei Erwärmung des Substratplättchens aufgrund des pyroelektrischen Effekts elektrisch auflädt
**dadurch gekennzeichnet, daß**
die Oberfläche sich bei Erwärmung positiv elektrisch auflädt und der Kristallschnitt ein um die x1 = x-Achse als Richtung der Wellenausbreitung (13) gedrehter Kristallschnitt (rot y) mit einem Winkel Δ = (180° + θ) zwischen der positiven y-Achse und der Flächennormalen (N) ist, worin θ ein für Lithiumtantalat-Kristallschnitte bekannter Winkel für geringe Leckwellenverluste ist und der Winkel Δ mit

$$180° + 25° < \Delta < 180° + 46°$$

bemessen ist.

**2.**   Oberflächenwellen-Bauelement,
mit einer Elektrodenstruktur (12,112) aus Aluminium als wenigstens Haupt-Materialbestandteil derselben auf einer Oberfläche (11) mit der Flächennormalen (N) eines pyroelektrischen und piezoelektrischen Kristall-Substratplättchens (10) aus Lithiumniobat, wobei diese Oberfläche (x1, x2, x3, 11) ein solcher Kristallschnitt (x, y, z) ist, daß diese Oberfläche sich bei Erwärmung des Substratplättchens aufgrund des pyroelektrischen Effekts elektrisch auflädt,
**dadurch gekennzeichnet, daß**
die Oberfläche sich bei Erwärmung positiv elektrisch auflädt und der Kristallschnitt ein um die x1 = x-Achse als Richtung der Wellenausbreitung (13) gedrehter Kristallschnitt (rot y) mit einem Winkel Δ = (180° + θ) zwischen der positiven y-Achse und der Flächennormalen (N) ist, worin θ ein für Lithiumniobat-Kristallschnitte bekannter Winkel für geringe Leckwellenverluste ist und der Winkel Δ mit

$$180° + 60° < \Delta < 180° + 74°$$

bemessen ist.

**3.**   Oberflächenwellen-Bauelement nach Anspruch 2,
bei dem der Winkel Δ mit

$$180° + 33° < \Delta < 180° + 47°$$

bemessen ist.

4.  Oberflächenwellen-Bauelement,
    mit einer Elektrodenstruktur (12,112) aus Aluminium als wenigstens Haupt-Materialbestandteil derselben auf einer Oberfläche (11) mit der Flächennormalen (N) eines pyroelektrischen und piezoelektrischen Kristall-Substratplättchens (10) aus Kaliumniobat, wobei diese Oberfläche (x1, x2, x3, 11) ein solcher Kristallschnitt (x, y, z) ist, daß diese Oberfläche sich bei Erwärmung des Substratplättchens aufgrund des pyroelektrischen Effekts elektrisch auflädt
    **dadurch gekennzeichnet, daß**
    das Substratplättchen aus Kaliumniobat ist, und die Oberfläche sich bei Erwärmung positiv elektrisch auflädt und der Kristallschnitt (x, y, z) ein um die x1 = x-Achse als Richtung der Wellenausbreitung (13) gedrehter Kristallschnitt (rot y) mit einem Winkel $\Delta = (180° + \theta)$ zwischen der positiven y-Achse und der Flächennormalen (N) ist, worin $\theta$ ein für Kaliumniobat -Kristallschnitte bekannter Winkel für geringe Leckwellenverluste ist.

5.  Bauelement nach einem der Ansprüche 1 bis 4,
    wobei auf oder in der Oberfläche der Elektrodenstrukturen(12) oder Finger (112) eine vergleichsweise zum elektrisch leitenden Material der Elektrodenstrukturen (12) harte Schicht (21,121) vorgesehen ist,
    wobei ein Dickenverhältnis (d1:d2;d'1:d'2) von elektrisch leitendem Material (d1;d'1) der Elektrodenstrukturen/Finger (12) und dem Material (d2;d'2) der harten Schicht (21,121) bei durch die vorgegebene Betriebsfrequenz vorgegebener optimaler Gesamtdicke (D = d1 + d2; = d'1 + d'2) der Elektrodenstrukturen so gewählt ist, daß vergrößerte Leistungsverträglichkeit erreicht ist.

6.  Bauelement nach einem der Ansprüche 1 bis 5,
    bei dem dieses Dickenverhältnis d1:d2; d'1:d'2 und dieser Winkel $\Delta$ in Abhängigkeit voneinander (Figur 5, 5a, 6) so gewählt sind, daß mit der harten Schicht optimal vergrößerte Leistungsverträglichkeit des Bauelements erreicht ist.

7.  Bauelement nach Anspruch 6,
    bei dem diese harte Schicht (21) aus anodisch oxidiertem Aluminiumoxid von Aluminium der Elektrodenstrukturen (12, 112) besteht.

8.  Bauelement nach Anspruch 7,
    bei dem die Dicke der Aluminiumoxid-Schicht (21) 10% bis 80% Anteil der Dicke der Elektrodenstrukturen (12), einschließlich der Schicht (21), aufweist.

9.  Bauelement nach Anspruch 5 oder 6,
    bei der diese harte Schicht (21,121) auf der Oberfläche der Elektrodenstrukturen (12) abgeschieden ist.

10. Bauelement nach Anspruch 9,
    bei dem das Abscheiden der harten Schicht (121) durch Sputtern erfolgt ist.

11. Bauelement nach Anspruch 10,
    bei dem die harte Schicht (121) aus einem Nitrid des Siliciums, Aluminiums und/oder Bors besteht.

12. Bauelement nach Anspruch 10,
    bei dem die harte Schicht (121) aus einem Silicid besteht.

13. Bauelement nach Anspruch 10,
    bei dem die harte Schicht (121) aus einem Borid besteht.

14. Bauelement nach Anspruch 10,
    bei dem die harte Schicht (121) aus einem Carbid besteht.

15. Bauelement nach Anspruch 10,
    bei dem die harte Schicht (121) eine amorphe KohlenstoffSchicht ist.

**16.** Bauelement nach Anspruch 10,
bei dem die harte Schicht (121) eine Diamantschicht ist.

**17.** Bauelement nach Anspruch 5 oder 6,
mit einer Aluminiumoxid-Schicht (21) auf den freien Flächen wenigstens der Finger (112) der Elektrodenstrukturen oder Finger (12, 112) mit einer Gesamtdicke der einzelnen Finger (112) D = 0,03 bis 0,15-fachem der Wellenlänge der Oberflächenwelle (13),
wobei gilt

$$D = d1 + d2$$

mit

d1     der Dicke des leitenden Materials der Finger (112) und
d2     der Dicke der Schicht (21) auf den Fingern,

und wobei wenigstens angenähert gilt:
d1 : d2 = 0,1 bei einem Winkel θ = 30° und
d1 : d2 = 2,5 bei einem Winkel θ = 38°
mit dazu im wesentlichen linearer Abhängigkeit für daraus zu entnehmende Zwischenwerte des Dickenverhältnisses d1:d2 für Werte des Winkels θ zwischen 30° und 38°-Winkel für optimale Leistungsverträglichkeit.

**18.** Bauelement nach einem der Ansprüche 5 bis 17,
mit einem Winkel θ der Orientierung zwischen größer 35° und kleiner 38° bei einem Dickenverhältnis d1:d2 von wenigstens angenähert 3:1.

**19.** Bauelement nach Anspruch 5 oder 9 bis 16,
mit einer über den Elektrodenstrukturen (12,112') und deren wenigstens näherer Umgebung auf der Substratoberfläche (11-Figuren 2, 3) abgeschiedenen Schicht mit einem Metallisierungsverhältnis η von 0,2 bis 0,8 und einer Gesamtdicke D=d'1 + d2 = 0,03 bis 0,15-fachem der Wellenlänge der Oberflächenwelle (13),
wobei D = d'1 + d'2 mit der Dicke d'1 des elektrisch leitenden Anteils (112') der Finger und d'2 der Dicke der abgeschiedenen Schicht (121) ist und wenigstens angenähert gilt:
daß die maximale Dicke d'2 der Schicht auf dem elektrisch leitenden Anteil (112') abhängig von dem Maß des vorliegenden Metallisierungsverhältnisses (η) gegenüber den aus den Figuren 5, 5a und 6 zu entnehmendem Dickenwert d2 für nur die Finger (112) bedeckende Schicht (21), reduziert zu bemessen ist: d'2 = η x d1.

**20.** Bauelement nach Anspruch 5 oder 9 bis 16,
mit einer über den Elektrodenstrukturen oder Finger (12,112') und deren wenigstens näherer Umgebung auf der Substratoberfläche (11) (Figuren 2, 3) abgeschiedenen Schicht mit einem Metallisierungsverhältnis η von 0,2 bis 0,8 und einer Gesamtdicke D=d'1 + d2 = 0,03 bis 0,15-fachem der Wellenlänge der Oberflächenwelle (13),
wobei D = d'1 + d'2 mit der Dicke (d'1) der Finger (112' und d'2) der Dicke der abgeschiedenen Schicht (121) ist und wenigstens angenähert gilt:

$$d'1:d'2 = \frac{(d1:d2) + (1 - \eta)}{\eta}$$

worin d1 und d2 Wertepaare mit zugehörigem Winkel θ sind, die sich aus den Figuren 5, 5a und 6 nach Anspruch 21 für eine diesbezügliche Ausführung nach Figur 1 ergeben.

**21.** Bauelement nach einem der Ansprüche 17 bis 20, mit Lithiumtantalat-Substratkristall.

**Claims**

**1.** Surface acoustic wave component
having an electrode structure (12, 112) composed of aluminium as at least the main material component of said structure on one surface (11) with the surface normal (N) of a pyroelectric and piezoelectric crystal substrate wafer (10) composed of lithium tantalate, with this surface (x1 x2, x3, 11) being a crystal cut (x, y, z) such that this surface is electrically charged by the piezoelectric effect when the substrate wafer is heated,
**characterized in that**
during heating, the surface is positively electrically charged and the crystal cut is a crystal cut (red y) which is rotated about the x1 = x axis as the direction of wave propagation (13), with an angle $\Delta = (180° + \theta)$ between the positive y axis and the surface normal (N) where $\theta$ is an angle, which is known for lithium tantalate crystal cuts, for small leakage wave losses, and the angle $\Delta$ is such that

$$180° + 25° < \Delta < 180° + 46°.$$

2. Surface acoustic wave component
having an electrode structure (12, 112) composed of aluminium as at least the main material component of said structure on one surface (11) with the surface normal (N) of a pyroelectric and piezoelectric crystal substrate wafer (10) composed of lithium tantalate, with this surface (x1, x2, x3, 11) being a crystal cut (x, y, z) such that this surface is electrically charged by the pyroelectric effect when the substrate wafer is heated,
**characterized in that**
during heating, the surface is positively electrically charged and the crystal cut is a crystal cut (red y) which is rotated about the x1 = x axis as the direction between the positive y axis and the surface normal (N) where $\theta$ is an angle, which is known for lithium niobate crystal cuts, for small leakage wave losses, and the angle $\Delta$ is such that

$$180° + 60° < \Delta < 180° + 74°.$$

3. Surface acoustic wave component according to Claim 2,
in which the angle $\Delta$ is

$$180° + 33° < \Delta < 180° + 47°.$$

4. Surface acoustic wave component
having an electrode structure (12, 112) composed of aluminium as at least the main material component of said structure on one surface (11) with the surface normal (N) of a pyroelectric and piezoelectric crystal substrate wafer (10) composed of potassium niobate, with this surface (x1, x2, x3, 11) being a crystal cut (x, y, z) such that this surface is electrically charged by the pyroelectric effect when the substrate wafer is heated,
**characterized in that**
the substrate wafer is composed of potassium niobate and the surface is positively electrically charged on heating, and the crystal cut (x, y, z) is a crystal cut (red y) which is rotated about the x1 = x axis as the direction of wave propagation (13), with an angle $\Delta = (180° + \theta)$ between the positive y axis and the surface normal (N) where $\theta$ is an angle, which is known for potassium niobate crystal cuts, for small leakage wave losses.

5. Component according to one of Claims 1 to 4,
where a layer (21, 121), which is harder than the electrically conductive material of the electrode structures (12), is provided on or in the surface of the electrode structures (12) or fingers (112), where a thickness ratio (d1:d2; d'1:d'2) of the electrically conductive material (d1; d'1) of the electrode structures/fingers (12) and the material (d2; d'2) of the hard layer (21, 121) is chosen for the predetermined optimum overall thickness (D = d1 + d2; = d'1 + d'2) (which is governed by the predetermined operating frequency) of the electrode structures so as to achieve increased power carrying capacity.

6. Component according to one of Claims 1 to 5,
in which this thickness ratio d1:d2; d'1:d'2 and this angle $\Delta$ are chosen as a function of one another (Figures 5, 5a, 6) such that the hard layer results in the component having an optimally increased power carrying capacity.

7. Component according to Claim 6,
in which this hard layer (21) is composed of anodically oxidized (anodized) aluminium oxide of aluminium of the electrode structures (12, 112).

8. Component according to Claim 7,

in which the thickness of the aluminium oxide layer (21) represents 10% to 80% of the thickness of the electrode structures (12) including the layer (21).

9. Component according to Claim 5 or 6,
in which this hard layer (21, 121) is deposited on the surface of the electrode structures (12).

10. Component according to Claim 9,
in which the hard layer (121) is deposited by sputtering.

11. Component according to Claim 10,
in which the hard layer (121) is composed of a nitride of silicon, aluminium and/or boron.

12. Component according to Claim 10,
in which the hard layer (121) is composed of a silicide.

13. Component according to Claim 10,
in which the hard layer (121) is composed of a boride.

14. Component according to Claim 10,
in which the hard layer (121) is composed of a carbide.

15. Component according to Claim 10,
in which the hard layer (121) is an amorphous carbon layer.

16. Component according to Claim 10,
in which the hard layer (121) is a diamond layer.

17. Component according to Claim 5 or 6,
having an aluminium oxide layer (21) on the free surfaces of at least the fingers (112) of the electrode structures or fingers (12, 112), with the individual fingers (112) having an overall thickness of $D = 0.03$ to $0.15$ times the wavelength of the surface acoustic wave (13),
where

$$D = d1 + d2$$

and
d1 is the thickness of the conductive material of the fingers (112) and
d2 is the thickness of the layer (21) on the fingers,
and where, at least approximately:
d1 : d2 = 0.1 for an angle of $\theta = 30°$ and
d1 : d2 = 2.5 for an angle of $\theta = 38°$ with an essentially linear relationship for intermediate values of the thickness ratio d1:d2 which can be deduced from this for values of the angle $\theta$ between $30°$ and $38°$ - angles for the optimum power carrying capacity.

18. Component according to one of Claims 5 to 17,
having an angle $\theta$ for the orientation which is between more than $35°$ and less than $38°$ for a thickness ratio d1: d2 of at least approximately 3:1.

19. Component according to Claim 5 or 9 to 16,
having a layer, which is deposited over the electrode structures (12, 112') and over the at least relatively close surrounding area on the substrate surface (11 - Figures 2, 3), with a metallization ratio $\eta$ of 0.2 to 0.8 and an overall thickness of D=d'1 + d2 = 0.03 to 0.15 times the wavelength of the surface acoustic wave (13),
where D = d'1 + d'2, and d'1 is the thickness of the electrically conductive component (112') of the fingers, and d'2 is the thickness of the deposited layer (121), and, at least approximately:
the maximum thickness d'2 of the layer on the electrically conductive component (112'), depending on the magnitude of the metallization ratio ($\eta$) that is present, can be designed to be less than the thickness value d2 [sic], which is shown in Figures 5, 5a and 6, for the layer (21) which covers the fingers (112): d'2 = $\eta \times$ d1.

**20.** Component according to Claim 5 or 9 to 16,
having a layer, which is deposited over the electrode structures or fingers (12, 112') and over the at least relatively close surrounding area on the substrate surface (11) (Figures 2, 3), with a metallization ratio η of 0.2 to 0.8 and an overall thickness of D=d'1 + d2 = 0.03 to 0.15 times the wavelength of the surface acoustic wave (13), where D = d'1 + d'2, with the thickness (d'1) of the fingers (112' and d'2) of the thickness of the deposited layer [sic], and, at least approximately:

$$d'1 : d'2 = \frac{(d1 : d2) + (1 - \eta)}{\eta}$$

where d1 and d2 are value pairs with an associated angle θ, which result from Figures 5, 5a and 6 according to Claim 21 for an embodiment relating to this as shown in Figure 1.

**21.** Component according to one of Claims 17 to 20, with a lithium tantalate substrate crystal.


**Revendications**

**1.** Composant à ondes de surface,
ayant une structure à électrodes (12, 112) en aluminium comme constituant de matériau au moins principal sur une surface (11) de normale (N) à la surface d'une plaquette de substrat en cristal pyroélectrique et piézoélectrique (10) en tantalate de lithium, cette surface (x1, x2, x3, 11) étant une section de cristal (x, y, z) telle que cette surface se charge électriquement lors de l'échauffement de la plaquette de substrat en raison de l'effet pyroélectrique,
**caractérisé par le fait que** la surface se charge électriquement positivement lors de l'échauffement et que la section de cristal est une section de cristal (rot y) tournée autour de x1 = axe des x en tant que direction de la propagation des ondes (13) avec un angle Δ = (180° + θ) entre l'axe y positif et la normale (N) à la surface, θ étant un angle connu pour des sections de cristal en tantalate de lithium comme donnant des pertes petites d'ondes de fuite et l'angle Δ étant dimensionné selon

$$180° + 25° < Δ < 180° + 46°$$


**2.** Composant à ondes de surface,
ayant une structure à électrodes (12, 112) en aluminium comme constituant de matériau au moins principal sur une surface (11) de normale (N) à la surface d'une plaquette de substrat en cristal pyroélectrique et piézoélectrique (10) en niobate de lithium, cette surface (x1, x2, x3, 11) étant une section de cristal (x, y, z) telle que cette surface se charge électriquement lors de l'échauffement de la plaquette de substrat en raison de l'effet pyroélectrique,
**caractérisé par le fait que** la surface se charge électriquement positivement lors de l'échauffement et que la section de cristal est une section de cristal (rot y) tournée autour de x1 = axe des x en tant que direction de la propagation des ondes (13) avec un angle Δ = (180° + θ) entre l'axe y positif et la normale (N) à la surface, θ étant un angle connu pour des sections de cristal en niobate de lithium comme donnant. des pertes petites d'ondes de fuite et l'angle Δ étant dimensionné selon

$$180° + 60° < Δ < 180° + 74°$$


**3.** Composant à ondes de surface selon la revendication 2,
dans lequel l'angle Δ est dimensionné selon

$$180° + 33° < Δ < 180° + 47°$$


**4.** Composant à ondes de surface,
ayant une structure à électrodes (12, 112) en aluminium comme constituant de matériau au moins principal sur une surface (11) de la normale (N) à la surface d'une plaquette de substrat en cristal pyroélectrique et piézoélectrique (10) en niobate de potassium, cette surface (x1, x2, x3, 11) étant une section de cristal (x, y, z) telle que cette surface se charge électriquement lors de l'échauffement de la plaquette de substrat en raison de l'effet pyroélectrique,

   **caractérisé par le fait que** la plaquette de substrat est en niobate de potassium, la surface se charge électriquement positivement lors de l'échauffement et que la section de cristal (x, y, z) est une section de cristal (rot y) tournée autour de x1 = axe des x en tant que direction de la propagation des ondes (13) avec un angle $\Delta$ = $(180° + \theta)$ entre l'axe y positif et la normale (N) à la surface, $\theta$ étant un angle connu pour des sections de cristal en niobate de potassium comme donnant des pertes petites d'ondes de fuite.

5. Composant selon l'une des revendications 1 à 4,
   dans lequel une couche dure (21, 121) comparée au matériau électriquement conducteur des structures d'électrodes (12) est prévue sur ou dans la surface des structures d'électrodes (12) ou des doigts (112),
   dans lequel un rapport d'épaisseur (d1 : d2 ; d'1 : d'2) entre le matériau électriquement conducteur (d1 ; d'1) des structures/doigts d'électrodes (12) et le matériau (d2 ; d'2) de la couche dure (21, 121) pour une épaisseur totale optimale (D = d1 + d2 ; = d'1 + d'2), prédéterminée par la fréquence de fonctionnement prédéterminée, des structures d'électrodes est choisi de manière à atteindre une plus grande compatibilité de puissance.

6. Composant selon l'une des revendications 1 à 5,
   dans lequel ce rapport d'épaisseur d1 : d2 ; d'1 : d'2 et cet angle $\Delta$ sont choisis l'un en fonction de l'autre (figures 5, 5a, 6) de manière à obtenir avec la couche dure une compatibilité de puissance accrue optimale du composant.

7. Composant selon la revendication 6,
   dans lequel cette couche dure (21) est en oxyde d'aluminium formé par oxydation anodique à partir de l'aluminium des structures d'électrodes (12, 112).

8. Composant selon la revendication 7,
   dans lequel l'épaisseur de la couche d'oxyde d'aluminium (21) représente 10 % à 80 % de l'épaisseur des structures d'électrodes (12), y compris la couche (21).

9. Composant selon la revendication 5 ou 6,
   dans lequel cette couche dure (21, 121) est déposée sur la surface des structures d'électrodes (12).

10. Composant selon la revendication 9,
    dans lequel le dépôt de la couche dure (121) est effectué par pulvérisation cathodique.

11. Composant selon la revendication 10,
    dans lequel la couche dure (121) est en nitrure de silicium, d'aluminium et/ou de bore.

12. Composant selon la revendication 10,
    dans lequel la couche dure (121) est en siliciure.

13. Composant selon la revendication 10,
    dans lequel la couche dure (121) est en carbure.

14. Composant selon la revendication 10,
    dans lequel la couche dure (121) est en borure.

15. Composant selon la revendication 10,
    dans lequel la couche dure (121) est une couche de carbone amorphe.

16. Composant selon la revendication 10,
    dans lequel la couche dure (121) est une couche de diamant.

17. Composant selon la revendication 5 ou 6,
    ayant une couche d'oxyde d'aluminium (21) sur les surfaces libres au moins des doigts (112) des structures d'électrodes ou des doigts (12, 112) avec une épaisseur totale des différents doigts (112) D = 0,03 à 0,15 fois la longueur d'onde de l'onde de surface (13),
    dans lequel on a :

$$D = d1 + d2$$

avec

d1 épaisseur du matériau conducteur des doigts (112) et

d2 épaisseur de la couche (21) sur les doigts,

et dans lequel on a au moins approximativement :

d1 : d2 = 0,1 pour un angle θ = 30° et

d1 : d2 = 2,5 pour un angle θ = 38°

avec une dépendance quasi linéaire pour des valeurs intermédiaires, à en déduire, du rapport d'épaisseur d1 : d2 pour des valeurs de l'angle θ entre 30° et 38° en vue d'une compatibilité de puissance optimale.

**18.** Composant selon l'une des revendications 5 à 17, ayant un angle θ de l'orientation qui est supérieur à 35° et inférieur à 38° pour un rapport d'épaisseur d1 : d2 d'au moins approximativement 3 : 1.

**19.** Composant selon la revendication 5 ou 9 à 16,

ayant une couche déposée au-dessus des structures d'électrodes (12, 112') et de leurs alentours au moins proches sur la surface de substrat (11 - figures 2, 3) avec un rapport de métallisation η de 0,2 à 0,8 et avec une épaisseur totale D = d'1 + d2 = 0,03 à 0,15 fois la longueur d'onde de l'onde de surface (13),

dans lequel on a D = d'1 + d'2 avec l'épaisseur d'1 de la part électriquement conductrice (112') des doigts et d'2 l'épaisseur de la couche déposée (121) et on a approximativement :

l'épaisseur maximale d'2 de la couche sur la part électriquement conductrice (112') en fonction de la mesure du rapport de métallisation existant (η) est à dimensionner avec une réduction : d'2 = η x d1 par rapport à la valeur d'épaisseur d2 à prendre dans les figures 5, 5a et 6 pour la couche (21) recouvrant seulement les doigts (112).

**20.** Composant selon la revendication 5 ou 9 à 16,

ayant une couche déposée au-dessus des structures d'électrodes ou doigts (12, 112') et de leurs alentours au moins proches sur la surface de substrat (11 - figures 2, 3) avec un rapport de métallisation η de 0,2 à 0,8 et avec une épaisseur totale D = d'1 + d2 = 0,03 à 0,15 fois la longueur d'onde de l'onde de surface (13),

dans lequel on a D = d'1 + d2 avec l'épaisseur (d'1) des doigts (112') et (d'2) l'épaisseur de la couche déposée (121) et on a approximativement :

$$d'1 : d'2 = \frac{(d1:d2) + (1 - \eta)}{\eta}$$

d1 et d2 étant des couples de valeurs avec angle θ associé qui se déduisent des figures 5, 5a et 6 selon la revendication 21 pour une réalisation correspondante selon la figure 1.

**21.** Composant selon l'une des revendications 17 à 20,

ayant un cristal de substrat en tantalate de lithium.

FIG 1

$\Delta = 180° + \Theta$

FIG 7

FIG 2

FIG 3

# FIG 4

121

12

11

13

12

121

N

10

# FIG 6

nm

400 D

d2

300

200

100

d1
(A1)

4

30° 33° 36° θ → 39°

D=400nm (1GHz)

# FIG 5

EP 1 044 500 B1

## FIG 5a

EP 1 044 500 B1